Europäisches Patentamt

European Patent Office

Office européen des brevets

(19)

(11)     **EP 0 930 654 B1**

(12)     **EUROPÄISCHE PATENTSCHRIFT**

(45) Veröffentlichungstag und Bekanntmachung des Hinweises auf die Patenterteilung:
**13.03.2002   Patentblatt 2002/11**

(51) Int Cl.⁷: **H01L 27/112**, H01L 21/8246, H01L 21/336, H01L 29/78

(21) Anmeldenummer: **98123850.4**

(22) Anmeldetag: **15.12.1998**

(54) **Dreidimensionale Halbleiter-Speicherzellenanordnung und Verfahren zu ihrer Herstellung**

Three-dimensional semiconductor memory array and method for its manufacture

Structure tridimensionelle de cellule de mémoire semiconductrice et son procédé de fabrication

(84) Benannte Vertragsstaaten:
**DE FR GB IE IT**

(30) Priorität: **15.01.1998   DE 19801308**

(43) Veröffentlichungstag der Anmeldung:
**21.07.1999   Patentblatt 1999/29**

(73) Patentinhaber: **Infineon Technologies AG
81669 München (DE)**

(72) Erfinder:
• **Reisinger, Hans, Dr.
82031 Grünwald (DE)**
• **Stengl, Reinhard, Dr.
86391 Stadtbergen (DE)**
• **Hofmann, Franz, Dr.
80995 München (DE)**
• **Krautschneider, Wolfgang, Dr.
83104 Hohenthann (DE)**
• **Willer, Josef, Dr.
85521 Riemerling (DE)**

(74) Vertreter:
**Patentanwaltskanzlei WILHELM & BECK
Nymphenburger Strasse 139
80636 München (DE)**

(56) Entgegenhaltungen:
EP-A- 0 164 095          EP-A- 0 783 181
DE-A- 4 417 150          US-A- 4 992 838
US-A- 5 383 149          US-A- 5 510 287

**Beschreibung**

Speicherzellen werden in weiten Technologiegebieten eingesetzt. Bei den Speicherzellen kann es sich sowohl um Festwertspeicher handeln, die als ROM (Read Only Memory) bezeichnet werden, als auch um programmierbare Speicher, die als PROM (Programmable ROM) bezeichnet werden.

Speicherzellenanordnungen auf Halbleitersubstraten zeichnen sich dadurch aus, daß sie einen wahlfreien Zugriff auf die in ihnen gespeicherte Information erlauben. Sie enthalten eine Vielzahl von Transistoren. Beim Lesevorgang wird festgestellt, ob ein Strom durch einen Transistor fließt oder nicht. Einem Stromfluß durch den Transistor oder einem Sperren des Transistors werden dabei die logischen Zustände 1 oder 0 zugeordnet. Üblicherweise wird die Speicherung der Information dadurch bewirkt, daß MOS-Transistoren eingesetzt werden, deren Kanalgebiete eine der gewünschten Sperreigenschaft entsprechende Dotierung aufweisen.

In der DE-OS 195 10 042 ist eine Speicherzellenanordnung vorgeschlagen worden, die in Zeilen angeordnete MOS-Transistoren enthält. In jeder Zeile sind die MOS-Transistoren in Reihe geschaltet. Zur Erhöhung der Speicherdichte sind benachbarte Zeilen jeweils abwechselnd am Boden von streifenförmigen Längsgräben und zwischen benachbarten streifenförmigen Längsgräben an der Oberfläche des Substrats angeordnet. Miteinander verbundene Source/Drain-Gebiete sind als zusammenhängendes dotiertes Gebiet ausgebildet. Durch ein zeilenweises Ansteuern ist es möglich, diese Speicherzellenanordnung auszulesen.

Diese Speicherzellenanordnung zeichnet sich dadurch aus, daß der für die Speicherzellen erforderliche Flächenbedarf von 4 $F^2$ auf 2 $F^2$ verringert wurde, wobei F die minimale Strukturbreite des für die Herstellung eingesetzten photolitographischen Prozesses ist. Nachteilig ist jedoch, dass eine weitere Erhöhung der Anzahl der Speicherzellen je Flächeneinheit hierbei nicht möglich ist.

Aus US-PS 5 409 852 ist bekannt, zur Erhöhung der Packungsdichte MOS-Transistoren übereinander anzuordnen. Zur Kontaktierung derartiger Transistoren werden vergrabene, dotierte Schichten, die entsprechend strukturiert sind und die mit metallischen Kontakten verbunden sind, eingesetzt.

Aus der DE 44 17 170 ist eine Speicherzellenanordnung mit selbstverstärkenden dynamischen MOS-Transistorspeicherzellen bekannt, bei der die Auswahltransistoren und die Speichertransistoren als vertikale Transistoren realisiert sind, die über einen gemeinsamen Knoten in Reihe geschaltet sind, wobei zwischen dem gemeinsamen Knoten und einer Gate-Elektrode der Speichertransistoren eine weitere Diodenstruktur ausgebildet ist.

Aus der US-A 5 383 149 ist eine weitere Speicherzellenanordnung bekannt, bei der vertikal ausgebildete Transistoren über eine gemeinsame Source-Drain-Schicht miteinander verschaltet werden, wobei zwei vertikale Transistoranordnungen übereinander angeordnet sind, die über eine gemeinsame Wortleitung angesteuert werden.

Der Erfindung liegt die Aufgabe zugrunde, die Nachteile des Standes der Technik zu vermeiden. Insbesondere soll eine Speicherzellenanordnung geschaffen werden, bei der eine möglichst große Anzahl von Speicherzellen auf möglichst kleinem Raum angeordnet werden kann.

Diese Aufgabe wird gelöst durch eine Speicherzellenanordnung gemäß Anspruch 1 sowie ein Verfahren zu deren Herstellung gemäß Anspruch 14. Weitere Ausgestaltungen der Erfindung gehen aus den übrigen Ansprüchen hervor.

Auf einer Hauptfläche eines Halbleitersubstrats sind Stege angeordnet, die über die Hauptfläche des Halbleitersubstrats hinausragen. Die Stege weisen jeweils einen Stapel dotierter Schichten auf, wobei einander benachbarte Schichten jeweils vom entgegengesetzten Leitfähigkeitstyp dotiert sind. Jeweils drei benachbarte dotierte Schichten bilden zwei Source-Drain-Gebiete und ein Kanalgebiet eines feldeffektgesteuerten Transistors. Mindestens eine Seitenwand des Stapels ist jeweils mit einem Gate-Dielektrikum versehen. Quer zu den Stegen verlaufen Wortleitungen, die jeweils im Bereich der Seitenwände der Stapel an das Gate-Dielektrikum angrenzen. Die als Source-Drain-Gebiet wirkenden dotierten Schichten wirken gleichzeitig als Bitleitungen der Speicherzellenanordnung. In dem Speicher sind soviele dotierte Schichten vorgesehen, dass durch die dotierten Schichten mindestens zwei übereinander angeordnete Transistoren realisiert werden, die über eine gemeinsame dotierte Schicht, die als gemeines Source-/Drain-Gebiet wirkt, in Reihe verschaltet sind.

In dieser Speicherzellenanordnung definiert der Kreuzungspunkt zwischen einer der Wortleitungen und einer dotierten Schicht, die als Kanalgebiet wirkt sowie den beiden benachbarten dotierten Schichten, die als Source-/Drain-Gebiete wirken, jeweils einen Transistor. Benachbarte Transistoren, die in Reihe verschaltet sind, weisen ein gemeinsames Source-/Drain-Gebiet auf. Der Stromfluß in den Transistoren verläuft parallel zur Seitenwand des Stapels.

Vorzugsweise sind in dem Stapel so viele dotierte Schichten vorgesehen, daß in den Stegen jeweils zwischen 4 und 32 Transistoren übereinander angeordnet sind, die jeweils über eine gemeinsame dotierte Schicht, die als gemeinsames Source-/Drain-Gebiet wirkt, in Reihe verschaltet sind. Dadurch wird eine hohe Packungsdichte erzielt.

Die Stege weisen parallel zur Hauptfläche des Substrats einen streifenförmigen Querschnitt auf. Benachbarte Stege sind vorzugsweise parallel zueinander angeordnet.

Quer zu den Stegen verlaufen jeweils mehrere Wortleitungen, die zueinander beabstandet sind. Auf diese Weise sind entlang der Längsausdehnung der Stege eine Vielzahl von Transistoren nebeneinander angeordnet, die über die jeweilige Wortleitung ansteuerbar sind.

Die Erfindung sieht also vor, eine Speicherzellenanordnung zu schaffen, bei der alle drei Dimensionen des Raumes zur Speicherung und/oder Weiterleitung von Informationen genutzt werden. Dies erfolgt dadurch, daß eine Anzahl N von Transistoren übereinander angeordnet ist. Dabei verringert sich der pro Speicher erforderliche Flächenbedarf von $4\,F^2$ auf $4\,F^2/N$. Diese Flächenreduzierung wird durch eine dreidimensionale Integration mit Stapelung von N Transistoren übereinander erzielt.

Durch die dargestellte Stapelung von Transistoren wird der erfindungsgemäße Zweck der Flächenreduzierung bewirkt. Die anderen Maßnahmen vereinfachen die Herstellbarkeit der Speicherzellenanordnung und führen zu einer möglichst hohen Schaltgeschwindigkeit. Es kommt daher nicht auf ein einzelnes der dargestellten Merkmale an. Die hier verwendeten Begriffe sind in ihrer weitesten Bedeutung gemeint.

Insbesondere der Begriff des Gatedielektrikums ist in keiner Weise einschränkend gemeint. Er umfaßt sowohl ein konventionelles Dielektrikum, als auch ein Dielektrikum mit einem erhöhten Ladungsträgereinfangsquerschnitt, das zum Beispiel $Si_3N_4$, $Ta_2O_5$, $Al_2O_3$ oder $TiO_2$ enthält. Es kann sich hierbei jedoch auch um ein komplexeres Gatedielektrikum handeln, beispielsweise mit einem Aufbau der Folge ONO (Oxid/ Nitrid/ Oxid), die eine erste $SiO_2$-Schicht, eine $Si_3N_4$-Schicht und eine zweite $SiO_2$-Schicht aufweist. Hierdurch ist es möglich, sowohl eine beim Herstellungsvorgang programmierbare Speicherzellenanordnung als auch eine während ihres Betriebes umprogrammierbare Speicherzellenanordnung zu gestalten.

Gemäß einer Ausgestaltung der Erfindung erfolgt die Speicherung von logischen Größen 0 und 1 dadurch, daß die Transistoren im Kanalgebiet unterschiedliche Dotierstoffkonzentrationen aufweisen. Transistoren, in denen der eine logische Wert gespeichert ist, weisen einen ersten Dotierstoffkonzentrationswert im Kanalgebiet auf, Transistoren, in denen ein zweiter logischer Wert gespeichert wird, weisen einen zweiten, vom ersten verschiedenen Dotierstoffkonzentrationswert auf. Die unterschiedlichen Dotierstoffkonzentrationen im Kanalgebiet bewirken unterschiedliche Einsatzspannungen des Transistors und erlauben so eine Unterscheidung zwischen den verschiedenen logischen Werten.

Ein zuverlässiges Auslesen der gespeicherten Information wird dadurch erreicht, daß sich die Konzentrationen der Dotierstoffe im Kanalgebiet um einen Faktor 2 bis 10 voneinander unterscheiden.

Es ist zweckmäßig, daß der eine Dotierstoffkonzentrationswert im Bereich zwischen $0{,}5 \times 10^{18}$ cm$^{-3}$ und $2 \times 10^{18}$ cm$^{-3}$ und der andere Dotierstoffkonzentrationswert im Bereich zwischen $0{,}5 \times 10^{19}$ cm$^{-3}$ und $2 \times 10^{19}$ cm$^{-3}$ liegt.

Gemäß einer anderen Ausgestaltung der Erfindung wird das Gatedielektrikum aus einem Material mit Ladungsträgerhaftstellen realisiert. Das Gatedielektrikum wird insbesondere aus einem Mehrschichtsystem gebildet, bei dem eine der Schichten einen erhöhten Ladungsträgereinfangquerschnitt als die benachbarten Schichten aufweist. In dem Gatedielektrikum eingefangene Ladungsträger beeinflussen die Einsatzspannung des Transistors. Durch gezieltes Einbringen der Ladungsträger wird in dieser Ausgestaltung der Speicherzellenanordnung logische Information gespeichert.

Gemäß einer weiteren Ausgestaltung der Erfindung enthalten die Stege jeweils zwei durch einen Isolationsbereich getrennte Schichtstapel. Der Isolationsbereich kann dabei ebenfalls streifenförmig ausgebildet sein und zwei streifenförmige Schichtstapel definieren. In dieser Ausgestaltung werden an gegenüberliegenden Seitenwänden der Stege Transistoren realisiert. Auf diese Weise wird die Packungsdichte weiter erhöht.

Es liegt dabei im Rahmen der Erfindung, je zwei in benachbarten Stegen angeordnete Schichtstapel über ein dotiertes Gebiet, das im Halbleitersubstrat angeordnet ist und das an die Hauptfläche angrenzt, in Reihe zu verschalten. Ferner können in einem Steg enthaltene Schichtstapel durch eine gemeinsame leitende Schicht, die oberhalb der Schichtstapel und des Isolationsbereichs angeordnet ist, in Reihe verschaltet sein.

Durch die in Reiheverschaltung benachbarter Schichtstapel wird die Anzahl der elektrischen Ebenen erhöht.

Die erfindungsgemäße Speicherzellenanordnung ist nicht auf eine spezielle Topologie ihrer Bestandteile beschränkt. Die hier dargestellte räumliche Anordnung ist jedoch besonders vorteilhaft. Während die aktiven Gebiete der Transistoren aufeinander liegen, können die anderen Schaltungselemente eine beliebige Anordnung aufweisen. Auch die anderen Bestandteile der Transistoren können auf verschiedene Weise angeordnet sein. Eine besonders gute Raumausnutzung läßt sich jedoch dadurch erzielen, daß das Gatedielektrikum senkrecht zu einer Hauptfläche des Halbleitersubstrates angeordnet ist. Eine derartige Anordnung läßt sich zweckmäßigerweise dadurch realisieren, daß sich das Gatedielektrikum an einer Seitenwand des Steges befindet.

Die Kontaktierung der Bitleitungen, die in jedem der Stapel übereinander angeordnet sind, kann auf unterschiedliche Weise erfolgen. Insbesondere kann der Schichtstapel jeweils so strukturiert sein, daß jede der Bitleitungen am Rand des Zellenfeldes freigelegt wird. Der Schichtstapel weist in diesem Fall am Rand des Zellenfeldes einen treppenförmigen Querschnitt auf, bei dem die weiter unten im Schichtstapel angeordneten Bitleitungen die darüber angeordneten jeweils seitlich überragen.

Alternativ liegt es im Rahmen der Erfindung, die übereinander angeordneten Bitleitungen durch einen Dekoder anzusteuern. Vorzugsweise wird der Dekoder in dem Schichtstapel realisiert. Dazu sind weitere Auswahlleitungen vorgesehen, die den Schichtstapel kreuzen. Am Kreuzungspunkt zwischen einer der Auswahlleitungen und dem Schichtstapel wird dadurch jeweils ein Transistor des Dekoders realisiert. Der Aufbau der Transistoren des Dekoders ist somit analog zum Aufbau der Transistoren im Speicherzellenfeld. Jeder der Dekodertransistoren ist zwischen zwei benachbarte Bitleitungen geschaltet. Übereinander sind so viele Dekodertransistoren angeordnet und miteinander in Reihe verschaltet, wie im Speicherzellenfeld Transistoren übereinander angeordnet sind. Die unterschiedlichen Einsatzspannungen der Dekodertransistoren werden durch unterschiedliche Dotierstoffkonzentration im Kanalgebiet der Dekodertransistoren realisiert. Falls erforderlich können in einem Steg mehrere Dekoder realisiert sein, zwischen denen jeweils Transistoren der Speicherzellenanordnung angeordnet sind. Auf diese Weise wird ein zu großer Spannungsabfall über die Bitleitungen vermieden.

Zur Herstellung der Speicherzellenanordnung werden auf der Hauptfläche des Halbleitersubstrats dotierte Schichten aufgebracht, wobei benachbarte dotierte Schichten jeweils vom entgegengesetzten Leitfähigkeitstyp dotiert sind. Durch Strukurieren der dotierten Schichten werden Stege gebildet. Mindestens eine Seitenwand der Stege wird mit einem Gatedielektrikum versehen. Es werden Wortleitungen gebildet, die quer zu den Stegen verlaufen und die jeweils im Bereich der Seitenwand der Stege an das Gatedielektrikum angrenzen.

Vorzugsweise werden die dotierten Schichten durch Epitaxie aufgebracht. Vorzugsweise erfolgt die Epitaxie in situ dotiert. Sollen die unterschiedlichen Informationen in Form unterschiedlicher Dotierung im Kanalgebiet realisiert werden, so wird die Dotierstoffkonzentration für die MOS-Transistoren durch Implantation nach dem Aufwachsen der jeweiligen dotierten Schicht, die das Kanalgebiet enthält, eingestellt.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Zeichnungen.

Von den Zeichnungen zeigt

Figur 1    eine Seitenrißdarstellung eines Ausschnitts einer Speicherzellenanordnung,

Figur 2    ein vergrößerter Ausschnitt der in Figur 1 dargestellten Speicherzellenanordnung,

Figur 3    eine Schaltungsanordnung zur Ansteuerung von in der Speicherzellenanordnung enthaltenen Wort- und Bitleitungen.

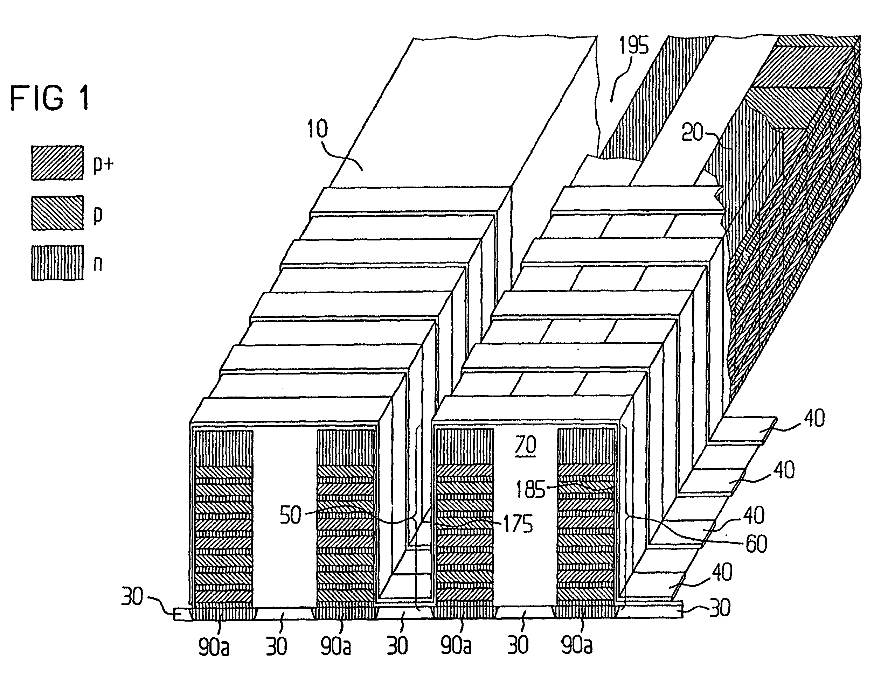

Bei der in Figur 1 dargestellten Speicherzellenanordnung sind zwei Speicherzellenzeilen bildende Stege 10, 20 dargestellt. Die Stege 10 und 20 befinden sich auf einer Oberfläche eines Halbleitersubstrats 30, das vorzugsweise aus monokristallinem Silizium besteht. Das Halbleitersubstrat 30 ist mindestens im Bereich des Zellenfeldes p-dotiert mit einer Dotierstoffkonzentration von etwa $10^{17}$ cm$^{-3}$. In dem Halbleitersubstrat 30 sind n-dotierte Gebiete 90a angeordnet. Sie weisen eine Tiefe von etwa 200 nm und eine Dotierstoffkonzentration von 4 x $10^{19}$ cm$^{-3}$ auf. Unterhalb jedes Steges 10, 20 sind zwei n-dotierte Gebiete 90a angeordnet.

Auf den Stegen 10 und 20 sind Wortleitungen 40 angeordnet. Die Wortleitungen 40 bestehen aus einem leitfähigen Material, beispielsweise aus einem Halbleitermaterial, das hoch dotiert ist, beispielsweise aus polykristallinem Silizium. Aus Silizium bestehende Wortleitungen 40 können zusätzlich silizidiert sein. Es ist jedoch gleichfalls möglich, daß die Wortleitungen 40 aus einem Metall bestehen. Die Wortleitungen 40 erstrecken sich im wesentlichen parallel zu der Oberfläche des Halbleitersubstrats 30 und dabei senkrecht zur Längsausdehnung der Stege 10 und 20.

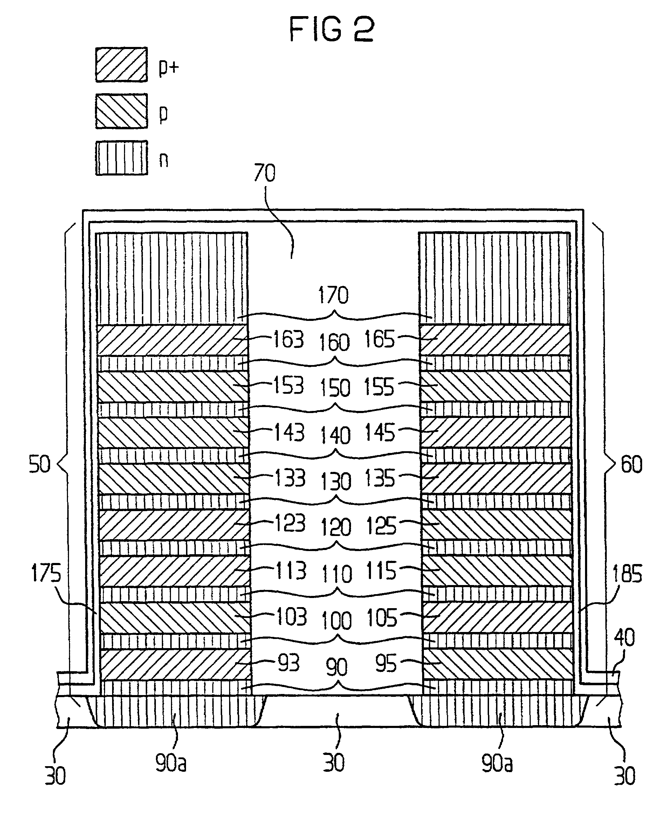

Der genaue Aufbau des Steges 20 ist in Figur 2 dargestellt. Die Stege 10 und 20 enthalten jeweils Schichtstapel 50 und 60, die durch ein Isolationsgebiet 70 voneinander getrennt sind. Das Isolationsgebiet 70 weist SiO$_2$ auf. Jeder der Schichtstapel 50 und 60 enthält mehrere übereinander angeordnete Schichten. Hierbei enthält der eine Schichtstapel 50 Schichten 90, 93, 100, 103, 110, 113, 120, 123, 130, 133, 140, 143, 150, 153, 160, 163 und 170. Der andere Schichtstapel 60 enthält die Schichten 90, 95, 100, 105, 110, 115, 120, 125, 130, 135, 140, 145, 150, 155, 160, 165 und 170. Die Schichten 90, 100, 110, 120, 130, 140, 150, 160 und 170 weisen eine möglichst hohe Dotierung vom n-Typ auf. Da die n-dotierten Schichten 90, 100, 110, 120, 130, 140, 150, 160 und 170 in der Speicherzelle als Bitleitungen dienen, weisen sie eine möglichst hohe Konzentration des Dotierstoffs, beispielsweise von Phosphor, auf. Um den Bahnwiderstand möglichst gering zu halten, beträgt die Konzentration des Dotierstoffs in den Bitleitungen vorzugsweise mehr als 5 x $10^{19}$ cm$^{-3}$. Die n-dotierten Schichten 90, 100, 110, 120, 130, 140, 150 und 160 weisen eine Dicke von jeweils 50 nm, die n-dotierte Schicht 170 eine Dicke von 400 nm auf.

Der eine Schichtstapel 50 weist zwischen den n-dotierten Schichten 90, 100, 110, 120, 130, 140, 150, 160 und 170 liegende p-dotierte Schichten 93, 103, 113, 123, 133, 143, 153 und 163 auf, die eine Dicke von jeweils 100 nm aufweisen. Hierbei sind die Schichten 93, 113, 123 und 163 hoch dotiert. Die anderen p-dotierten Schichten 103, 133, 143 und 153 sind hingegen niedrig dotiert. Der Schichtstapel 60 weist gleichfalls mit einem Dotierstoff des p-Typs dotierte Schichten 95, 105, 115, 125, 135, 145, 155 und 165 auf, die eine Dicke von jeweils 100 nm aufweisen. Hierbei sind die Schichten 105, 135, 145 und 165 hoch dotiert. Die weiteren p-dotierten Schichten 95, 115, 125 und 155 sind hingegen niedrig dotiert. Die niedrige Dotierung liegt vorzugsweise in der Größenordnung von $1 \times 10^{18}$ cm$^{-3}$, während die höhere Dotierung vorzugsweise in der Größenordnung von $1 \times 10^{19}$ cm$^{-3}$ liegt. Die niedrige und die höhere Dotierung haben unterschiedliche Einsatzspannungen und erlauben so die Unterscheidung eines gespeicherten logischen Zustandes 0 oder 1. Die Dotierung der mit einem Dotierstoff des n-Typs dotierten Bitleitungen beträgt vorzugsweise mindestens $4 \times 10^{19}$ cm$^{-3}$, wobei eine Dotierung von $1 \times 10^{20}$ cm$^{-3}$ oder mehr bevorzugt ist. Bei einer Konzentration des Dotierstoffs von $4 \times 10^{19}$ cm$^{-3}$ weisen die Bitleitungen einen spezifischen Widerstand von ungefähr 2 mΩ cm auf.

Durch die übereinander angeordneten Schichten 90, 95, 100, 105, 110, 115, 120, 125, 130, 135, 140, 145, 150, 155, 160, 165, 170 des Schichtstapels 60 werden acht übereinander liegende Transistoren gebildet. Ebenso bilden die übereinander angeordneten Schichten 90, 93, 100, 103, 110, 113, 120, 123, 130, 133, 140, 143, 150, 153, 160, 163, 170 des Schichtstapels 50 acht übereinander liegende Transistoren. Seitlich von den Schichtstapeln 50 und 60 befinden sich im Randbereich der Stege 10, 20 Isolationsgebiete 175 und 185, die SiO$_2$ enthalten. Die Isolationsgebiete 175 und 185 dienen als Gatedieiektrika für die durch die Schichtstapel 50 und 60 gebildeten Transistoren. Die als Gatedielektrika dienenden Isolationsgebiete 175 und 185 weisen eine Dicke von ungefähr 10 nm auf.

Um eine Programmierbarkeit der Speicherzellen zu erzielen, ist es zweckmäßig, daß das Gatedielektrikum aus einem Material besteht, das einen erhöhten Ladungsträgereinfangsquerschnitt aufweist. Dies kann beispielsweise dadurch geschehen, daß geeignete Nitride wie Si$_3$N$_4$ oder Oxide wie Ta$_2$O$_5$, Al$_2$O$_3$ oder TiO$_2$ eingesetzt werden.

Die Speicherzellenzeilen werden so gestaltet, daß sich der effektive Widerstand der Bitleitung zwischen einem ausgewählten Speichertransistor und der Peripherie aus dem spezifischen Widerstand der sogenannten dünnen Bitleitungen 100 bis 160, dem der sogenannten dicken Bitleitungen 90, 90a und 170 sowie deren Länge ergibt. Die Schicht 90 und das angrenzende n-dotierte Gebiet 90a wirken dabei gemeinsam als dicke Bitleitung. Bei einer Länge der Bitleitungen von 2000 F, einer Länge und Dicke der Bitleitungen, die jeweils die minimale Strukturbreite F beträgt, sowie einem spezifischen Widerstand von 1 mΩ cm (dies entspricht einer Dotierung von $1 \times 10^{20}$ cm$^{-3}$) und einer minimalen Strukturbreite F = 0,5 um ergibt sich ein Widerstand der dicken Bitleitungen von 40 kΩ. Es ist wünschenswert, daß der Widerstand der dünnen Bitleitungen höchstens 20 kΩ beträgt. Die Kapazität zwischen zwei Bitleitungen mit diesen Dimensionen beträgt 0,6 pF auf einer Länge von 1000 Zellen. Hiermit ergibt sich im ungünstigsten Fall maximal eine Zugriffszeit, die in der Größenordnung von 2 × (20 + 20) kΩ × 0,6 pF ≈ 50 ns liegt.

Der Abstand der Mitten benachbarter Wortleitungen beträgt zum Beispiel 2 F, wobei F die minimal herstellbare Strukturgröße ist, und beispielsweise zwischen 0,1 μm und 0,5 μm beträgt.

Die Stege 10 und 20 weisen seitliche Flanken auf. Die Wortleitungen 40 werden über diese seitlichen Flanken fortgeführt. An den seitlichen Flanken liegen Kreuzungspunkte zwischen den Bitleitungen 90, 100, 110, 120, 130, 140, 150, 160 und 170 und den Wortleitungen 40. Der Kreuzungsbereich wird als Speicherzelle definiert. Hierdurch ergibt sich ein Flächenbedarf von 4 F$^2$/N. Wenn N = 8 Bitleitungen übereinander angeordnet sind, beträgt der Flächenbedarf pro Speicherzelle 0,5 F$^2$, das heißt bei F = 0,5 % μm: 0,125 μm$^2$.

Der Bereich, in dem sich die Wortleitungen 40 mit den Bitleitungen 90, 100, 110, 120, 130, 140, 150, 160 und 170 kreuzen, entspricht dem Speicherzellenfeld der Speicherzeilenanordnung. Außerhalb dieses Speicherzellenfeldes sind nicht dargestellte Auswahlschalter vorgesehen. Diese Auswahlschalter weisen Bitauswahlleitungen auf. Mehrere übereinanderliegende Bitleitungen können durch eine nicht dargestellte Metallisierung zu einem Knoten zusammengefaßt werden. Zwischen dem Knoten und weiteren dotierten Schichten sind so viele Bitauswahlleitungen angeordnet, wie Bitleitungen in dem Knoten zusammengeführt werden.

Ein besonders günstiger Anschluß der Bitleitungen ergibt sich dadurch, daß ein Dekoder in das Zellenfeld integriert wird.

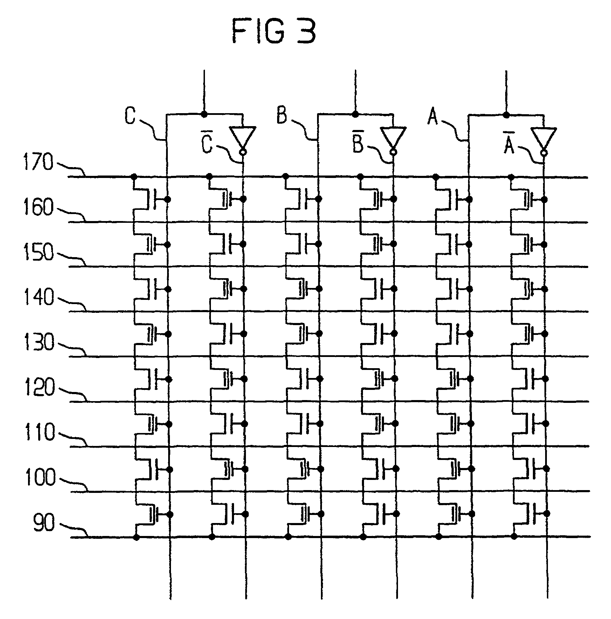

Diese Integration erfolgt vorzugsweise dreidimensional, insbesondere in der gleichen Struktur, wie sie die Stege 10 und 20 aufweisen. Zum Auslesen der Speicherzellenanordnung ist mindestens ein 1 aus 8 Dekoder vorgesehen. Er weist sechs aufeinanderfolgende Wortleitungen A, $\bar{A}$, B, $\bar{B}$, C, $\bar{C}$ (siehe Figur 3) auf, die es gestatten, jeweils zwei übereinanderliegende Bitleitungen (100 bis 160) mit den dicken Bitleitungen (90, 170) leitend zu verbinden, (zum Beispiel 150 mit 170 und 140 mit 90). Somit wird aus dem Stapel von acht übereinanderliegenden Transistoren eine Lage ausgewählt. Die MOS-Transistoren weisen unterschiedliche Einsatzspannungen auf. In einem ersten Steg des 1 aus 8 Dekoders sind jeweils ein MOS-Transistor mit höherer Einsatzspannung und ein MOS-Transistor mit geringerer Einsatzspannung alternierend übereinander angeordnet. In einem zweiten Steg des 1 aus 8 Dekoders sind jeweils zwei MOS-Transistoren mit höherer Einsatzspannung und zwei MOS-Transistoren mit geringerer Einsatzspannung alternierend übereinander angeordnet. In einem dritten Steg des 1 aus 8 Dekoders sind jeweils vier MOS-Transistoren mit höherer Einsatzspannung und vier MOS-Transistoren mit geringerer Einsatzspannung übereinander angeordnet. Je zwei Wortleitungen sind dabei entlang einander gegenüberliegenden Flanken des ersten Steges, des zweiten Steges bzw. des dritten Steges angeordnet. Die an gegenüberliegenden Flanken ein und desselben Steges in derselben Lage angrenzenden MOS-Transistoren sind dabei zueinander komplementär. Aus dem Zellenfeld werden nur die dicken Bitleitungen 90, 170 herausgeführt. Die dazwischen angeordneten dünnen Bitleitungen 100, 110, 120, 130, 140, 150, 160 werden durch entsprechende Ansteuerung des Dekoders ausgewählt.

Bei einem 1 aus N Dekoder beträgt das Raster der vom Zellenfeld in die Peripherie laufenden Bitleitungen 2 F. Bei einem 1 aus 2N Dekoder erhöht sich das Raster auf 4 F. Bei einem 1 aus 4N Dekoder beträgt das Raster sogar 8 F.

Die in Figur 1 dargestellte Speicherzellenanordnung kann wie folgt hergestellt werden:

In einem Substrat 30 aus zum Beispiel p-dotiertem monokristallinem Silizium mit einer Grunddotierstoffkonzentration von $2 \times 10^{15}$ cm$^{-3}$ wird eine p-dotierte Wanne mit einer Dotierstoffkonzentration von zum Beispiel $1 \times 10^{17}$ cm$^{-3}$ durch Implantation gebildet. Die Tiefe der p-dotierten Wanne beträgt vorzugsweise ungefähr 1 μm.

Die n-dotierten Gebiete 90a wird als Diffusionsgebiet durch die Implantation von Phosphoratomen in einer Dosis von ungefähr $5 \times 10^{15}$ at/cm$^{-2}$ und einer niedrigen Implantationsenergie von beispielsweise 100 keV über eine Fotomaske hergestellt. Somit können die n-dotierten Gebiete 90a in der fertigen Speicherzelle als Source oder Drain dienen. Die folgenden n- und niedrig p-dotierten Schichten werden durch epitaktisches Aufwachsen und In-situ-Dotierung hergestellt.

Die n-dotierten Schichten 90, 100, 110, 120, 130, 140, 150, 160 und 170 sowie die schwach-p-dotierten Schichten 95, 103, 115, 125, 133, 143, 153 und 155 wachsen bei Temperaturen in der Größenordnung von T = 1000 Grad Celsius und drücken in der Größenordnung von 100 Torr, d.h. 133 millibar, auf. Die n-Dotierung erfolgt in einem Gasgemisch aus $H_2$, $SiH_4$ und $AsH_3$. Die p-Dotierung erfolgt in einem Gasgemisch aus $H_2$, $SiH_4$ und $B_2H_6$.

Die höher p-dotierten Schichten werden dadurch hergestellt, daß nach einer epitaktischen Abscheidung der jeweiligen Schicht eine Implantation erfolgt. Für diese Implantation wird eine Fotomaske eingesetzt. Die Implantation erfolgt beispielsweise mit Bor einer Dosis von ungefähr $3 \times 10^{12}$ cm$^{-2}$ und einer Energie in der Größenordnung von 25 keV.

Die unterste n-dotierte Schicht 90 und das n-dotierte Gebiet 90a weisen eine größere Schichtdicke auf als die oberhalb davon befindlichen weiteren n-dotierten Schichten 100, 110, 120, 130, 140, 150 und 160. Die größere Dicke der Schicht 90, 90a erfolgt deshalb, weil sie sich teilweise innerhalb des vorzugsweise einkristallinen Halbleitersubstrats 30 befindet. Insbesondere dann, wenn das Halbleitersubstrat 30 aus einkristallinem Silizium besteht, ist es zweckmäßig, daß der Widerstand der Schicht 90 durch das daran angrenende n-dotierte Gebiet 90a verringert wird. Die oberste n-dotierte Schicht 170 ist niederohmiger ausgebildet als die Schichten 100, 110, 120, 130, 140, 150 und 160. Dies kann beispielsweise dadurch geschehen, daß die oberste n-dotierte Schicht 170 aus einem Silizid oder aus einem Metall besteht.

Anschließend wird durch Ätzen eine Grabenstruktur hergestellt, so daß sich zwischen den Stegen 10 und 20 ein Graben 195 bildet. Die Breite der Gräben und Stapel ist F, die Tiefe der Gräben liegt in der Größenordnung von N x (100 nm + 50 nm), wobei N vorzugsweise zwischen 4 und 32 liegt.

Nach dem Ätzen der Gräben 195 werden die Wortleitungen 40 abgeschieden. Dies erfolgt beispielsweise dadurch, daß zunächst bei einem der bekannten Schichterzeugungsverfahren, beispielsweise einem CVD (Chemical Vapour Deposition) - Verfahren, konform eine Schicht aus einem polykristallinen Halbleitermaterial oder aus einem Metall abgeschieden wird. Anschließend wird diese Schicht mittels konventioneller photolitographischer Prozeßschritte derart strukturiert, daß sich die einzelnen Wortleitungen 40 herausbilden. Der Abstand zwischen den einzelnen Wortleitungen 40 wird möglichst klein gewählt. Die untere Grenze zwischen dem Abstand zweier Mitten der Bitleitungen wird durch den eingesetzten photolitographischen Prozeß bestimmt. Der Abstand zwischen den Mitten zweier benachbarter Wortleitungen 40 beträgt somit F.

Nach dem Aufbringen der Wortleitungen 40 kann der zwischen den Stegen 10 und 20 befindliche Graben mit einem geeigneten isolierenden Material gefüllt werden. Ein derartiges Aufbringen eines isolierenden Materials ist insbesondere dann zweckmäßig, wenn oberhalb der Stege 10 und 20 weitere Ebenen, die elektrische Leitungen enthalten, aufgebracht werden sollen.

In einer Variante dieses Ausführungsbeispiels werden die Stapel übereinander angeordneter Transistoren eines Steges dadurch in Serie verschaltet, daß die zugehörigen Bitleitungen 170 miteinander verbunden werden. Darüber hinaus können die in verschiedenen Stegen angeordneten Stapel dadurch in Serie verschaltet werden, daß die zugehörigen n-dotierten Gebiete miteinander verbunden werden. Dieses erfolgt vorzugsweise durch Ausgestaltung als gemeinsames dotiertes Gebiet bzw. als gemeinsame Schicht. Dadurch läßt sich die Anzahl der elektrischen Ebenen erhöhen.

Die nachfolgende anhand von Figur 3 dargestellte Schaltungsanordnung zur Ansteuerung der Wort- und Bitleitungen ist besonders vorteilhaft.

Bei der in Figur 3 dargestellten Schaltungsanordnung handelt es sich um einen 1 aus 8 Dekoder. Der 1 aus 8 Dekoder ist wie oben erläutert aufgebaut. In Figur 3 werden für n-Kanal-MOS-Transistoren und für die dazu komplementären p-Kanal-MOS-Transistoren die allgemein üblichen Schaltzeichen verwendet. Dekoder sind Schaltnetze mit mehreren Dateneingängen, die so gesteuert werden, daß die in den Eingängen liegenden Binärinformationen nacheinander an einem gemeinsamen Ausgang liegen.

Bei dem in Figur 3 dargestellten 1 aus 8 Dekoder, der wie oben erläutert aufgebaut ist, erfolgt eine Auswahl von zwei beliebigen benachbarten Bitleitungen, die in dem Steg angeordnet sind. Hierdurch wird der zwischen den beiden Bitleitungen befindliche Transistor ausgelesen. Die beiden Bitleitungen werden durch entsprechende Ansteuerung des Dekoders mit den Bitleitungen der Ebenen 90 und 170 elektrisch verbunden. Die Bitleitungen 90 und 170 sind dicker und damit niederohmiger als die Bitleitungen der Ebenen 100 bis 160. Die Ebenen 90 und 170 werden an eine nicht dargestellte Auswerteelektronik weitergeleitet. Die Auswahl erfolgt für das gesamte Zellenfeld. Der 1 aus N Dekoder besteht aus $LOG_2$ (N) * 2 Wortleitungen, also beispielsweise aus 8 Wortleitungen bei N = 16, 10 Wortleitungen bei N = 32. Der 1 aus N Dekoder ist aufgebaut wie die Speicherbausteine des Zellenfeldes, also höher integriert als die übrige Peripherie, die vorzugsweise planar ausgebildet ist. Wesentlich ist, daß die Information im Bereich der Auswahlschaltung festgelegt ist. Zur Minimierung des effektiven Widerstandes der Bitleitungen ist es sinnvoll, den Dekoder im Zellenfeld öfter, zum Beispiel typischerweise alle 200 Wortleitungen zu wiederholen.

Ein derartiger Dekoder kann in das Zellenfeld integriert werden, ohne daß das Zellenfeld unterbrochen wird.

Es ist möglich, den effektiven Bitleitungswiderstand durch das Zusammenschalten von Bitleitungen weiter zu erniedrigen.

Die Erfindung ist nicht auf die dargestellten Ausführungsbeispiele beschränkt. Insbesondere können die Leitfähigkeitstypen n und p vertauscht werden.

Ferner liegt es im Rahmen der Erfindung, eine programmierbare Speicherzellenanordnung (PROM) zu schaffen. Dies kann in besonders zweckmäßiger Weise dadurch erfolgen, daß das Gatedielektrikum aus einem Material mit Haftstellen für elektrische Ladungsträger gebildet wird. Vorzugsweise wird es durch ein ONO-Dielektrikum (Oxid/Nitrid/Oxid) ersetzt, das eine erste $SiO_2$-Schicht, eine $Si_3N_4$-Schicht und eine zweite $SiO_2$-Schicht enthält.

Die Programmierung der Speicherzellenanordnung erfolgt dann durch Füllen der Haftstellen mittels Injektion von Elektronen. Dadurch wird die Einsatzspannung erhöht, bei der sich unterhalb der jeweiligen Wortleitung, die als Gateelektrode wirkt, ein leitender Kanal bildet. Der jeweilige Wert der Einsatzspannungserhöhung läßt sich über Zeit und Größe der angelegten Spannung während der Programmierung einstellen.

Bei einem ONO-Dielektrikum (Oxid/Nitrid/ Oxid) kann die Implantation im Zellenfeld entfallen, so daß eine Implantation nur im Dekoder erforderlich ist. Eine Speicherung von Ladung und damit eine Programmierung der Speicherzellenanordnung kann beim Einsatz eines ONO-Dielektrikums beispielsweise durch Fowler-Nordheim-Tunneln von Elektronen als auch durch Hot-Electron-Injection erfolgen.

Zum Einschreiben der Information durch Fowler-Nordheim-Tunneln wird die zu programmierende Speicherzelle über die zugehörige Wortleitung und die zugehörige Bitleitung ausgewählt. Die Bitleitung der Speicherzelle wird auf niedriges Potential gelegt, zum Beispiel auf 0 Volt. Die zugehörige Wortleitung wird dagegen auf hohes Potential gelegt, zum Beispiel auf 12 Volt. Die anderen Bitleitungen werden auf ein Potential angehoben, das so bemessen wird, daß es deutlich unterhalb der Programmierspannung liegt. Die anderen Wortleitungen werden auf ein Potential angehoben, das größer ist als die Summe aus dem Potential der anderen Bitleitungen und einer Schwellenspannung.

Bei der Schwellenspannung handelt es sich um jene Spannung, die erforderlich ist, daß in einer endlichen Zeit eine signifikante Erhöhung der Einsatzspannung des MOSFET durch Fowler-Nordheim-Tunneln erfolgt.

Da sich bei der Programmierung alle anderen Bitleitungen, die die ausgewählte Wortleitung kreuzen, auf höherem Potential befinden, werden die anderen Speicherzellen, die mit der ausgewählten Wortleitung verbunden sind, nicht programmiert. Die Speicherzellen sind vorzugsweise in einer NAND-Konfiguration verschaltet. Sie können daher so verbunden werden, daß ein Drainstrom durch die Speicherzellen fließt. Das hat den Vorteil, daß der gesamte Programmiervorgang sehr leistungsarm verläuft.

Die für die Programmierung einer Zelle erforderliche Energie beträgt ungefähr $E \approx 5 \times 10^{-12}$ Ladungsträger/cm$^2$ x e x 10 V x (0.5 μm x 0.1 μm) = 4 x $10^{-15}$ J.

Es ist gleichfalls möglich, daß die Programmierung durch Hot-Electron-Injection erfolgt. Ein Dekoder wählt eine Ebene aus, in der alle Zellen beschrieben werden, deren Wortleitungen auf einem hohen Potential liegen. Nicht auf dem hohen Potential liegende Wortleitungen werden dabei nicht programmiert. Zur Programmierung muß an den zu programmierenden MOS-Transistor eine Sättigungsspannung angelegt werden. Dazu wird die der Speicherzelle zugehörige Bitleitung zwischen ein niedriges Potential, vorzugsweise das Erdpotential und ein hohes Potential von üblicherweise ungefähr 6 Volt gelegt. Die der Speicherzelle zugeordnete Wortleitung wird auf ein Potential gelegt, bei dem sich der MOS-Transistor im Sättigungsbetrieb befindet. Die Spannung, die an der Wortleitung anliegt, ist kleiner als die angelegte Sättigungsspannung und beträgt üblicherweise ungefähr 4 Volt. Die anderen Wortleitungen werden auf ein höheres Potential gelegt, das beispielsweise in der Größenordnung von 7 Volt liegt. Diese Spannung wird in Abhängigkeit von der Dicke des Gatedielektrikums so gewählt, daß noch kein Fowler-Nordheim-Tunneln auftritt. Alle anderen Bitleitungen werden an beiden Enden auf gleiches Potential, zum Beispiel die Hälfte der Sättigungsspannung, gelegt.

Bei der Programmierung ist es wichtig, daß die nicht für den Programmiervorgang ausgewählten Lagen sich auf einem niedrigen Potential befinden.

Damit wird eine Programmierung von Speicherzellen, die entlang der ausgewählten Wortleitung an anderen Bitleitungen liegen, unterbunden und ein Stromfluß vermieden. Durch den Sättigungsbetrieb bei hoher Spannung entstehen im Kanalbetrieb des MOS-Transistors der ausgewählten Speicherzelle energiereiche Elektronen, die auch als heiße Elektronen (hot electrons) bezeichnet werden. Diese werden teilweise in das Gatedielektrikum injiziert. Die Elektronen werden von Haftstellen im Gatedielektrikum festgehalten und erhöhen die Schwellenspannung des MOS-Transistors. Je nach in der jeweiligen Speicherzelle einzuspeichernder Information wird auf diese Weise die Schwellenspannung des jeweiligen MOS-Transistors gezielt verändert.

Wegen der geringeren Programmierzeit und Programmierleistung ist die Fowler-Nordheim-Programmierung zu bevorzugen.

**Patentansprüche**

1. Speicherzellenanordnung,

   - bei der auf einer Hauptfläche eines Halbleitersubstrats Stege angeordnet sind, die über die Hauptfläche des Halbleitersubstrats hinausragen,

   - bei der die Stege jeweils einen Stapel dotierter Schichten aufweisen, in dem einander benachbarte Schichten jeweils vom entgegengesetzten Leitfähigkeitstyp dotiert sind,

   - bei der jeweils drei benachbarte dotierte Schichten zwei Source-/Drain-Gebiete und ein Kanalgebiet eines Transistors bilden,

   - bei der mindestens eine Seitenwand der Stapel mit einem Gatedielektrikum versehen ist,

   - bei der quer zu den Stegen Wortleitungen verlaufen, die jeweils im Bereich der Seitenwände der Stapel an das Gatedielektrikum angrenzen,

   - bei der als Source-/Drain-Gebiet wirkende dotierte Schichten als Bitleitungen wirken,

   - bei der in dem Stapel so viele dotierte Schichten vorgesehen sind, daß durch die dotierten Schichten mindestens zwei übereinander angeordnete Transistoren realisiert werden, die über eine gemeinsame dotierte Schicht, die als gemeinsames Source-/Drain-Gebiet wirkt, in Reihe verschaltet sind.

2. Speicherzellenanordnung nach Anspruch 1, bei der in dem Stapel so viele dotierte Schichten vorgesehen sind, daß in den Stegen jeweils zwischen 4 und 32 Transistoren übereinander angeordnet sind, die jeweils über eine gemeinsame dotierte Schicht, die als gemeinsames Source-/Drain-Gebiet wirkt, in Reihe verschaltet sind.

3. Speicherzellenanordnung nach Anspruch 1 oder 2, bei der quer zu den Stegen jeweils mehrere Wortleitungen verlaufen, die zueinander beabstandet sind.

4. Speicherzellenanordnung nach einem der Ansprüche 1 bis 3, bei der als Kanalgebiet wirkende dotierte Schichten jeweils im Kreuzungsbereich mit einer der Wortleitungen eine Dotierstoffkonzentration aufweisen, die einem von zwei unterschiedlichen Dotierstoffkonzentrationswerten entspricht.

5. Speicherzellenanordnung nach Anspruch 4, bei der sich die zwei unterschiedlichen Dotierstoffkonzentrationswerte um einen Faktor 2 bis 10 voneinander unterscheiden.

6. Speicherzellenanordnung nach Anspruch 4 oder 5,

   - bei der der eine der zwei unterschiedlichen Dotierstoffkonzentrationswerte zwischen $0,5 \times 10^{18}$ cm$^{-3}$ und $2 \times 10^{18}$ cm$^{-3}$ liegt,

   - bei der der andere der zwei unterschiedlichen Dotierstoffkonzentrationswerte zwischen $0,5 \times 10^{19}$ cm$^{-3}$ und $2 \times 10^{19}$ cm$^{-3}$ liegt.

7. Speicherzellenanordnung nach einem der Ansprüche 1 bis 6, bei der das Gatedielektrikum ein Material mit Ladungsträgerhaftstellen enthält.

8. Speicherzellenanordnung nach einem der Ansprüche 1 bis 7, bei der das Gatedielektrikum ein Mehrschichtsystem enthält.

9. Speicherzellenanordnung nach einem der Ansprüche 1 bis 8, bei der die Stege jeweils zwei durch einen Isolationsbereich getrennte Schichtstapel enthalten.

10. Speicherzellenanordnung nach Anspruch 9, bei der je zwei in benachbarten Stegen angeordnete Schichtstapel über ein dotiertes Gebiet, das im Halbleitersubstrat angeordnet ist und das an die Hauptfläche angrenzt, in Reihe verschaltet sind.

11. Speicherzellenanordnung nach Anspruch 9 oder 10, bei der in einem Steg enthaltene Schichtstapel durch eine gemeinsame leitende Schicht, die oberhalb der Schichtstapel und des Isolationsbereichs angeordnet ist, in Reihe verschaltet sind.

**12.** Speicherzellenanordnung nach einem der Ansprüche 1 bis 11, bei der ein Dekoder zur Ansteuerung der Bitleitungen vorgesehen ist, der zwischen je zwei Bitleitungen geschaltete MOS-Transistoren aufweist.

**13.** Speicherzellenanordnung nach Anspruch 12, bei der der Dekoder in Reihe verschaltete MOS-Transistoren enthält, die in den Stegen übereinander angeordnet sind.

**14.** Verfahren zur Herstellung einer Speicherzellenanordnung

- bei dem auf eine Hauptfläche eines Halbleitersubstrats dotierte Schichten übereinander aufgebracht werden, wobei benachbarte dotierte Schichten jeweils vom entgegengesetzten Leitfähigkeitstyp dotiert sind,

  wobei jeweils drei benachbarte dotierte Schichten zwei Source-Drain-Gebiete und ein Kanalgebiet eines Transistors bilden,
  wobei soviele dotierte Schichten vorgesehen sind, dass durch die dotierten Schichten mindestens zwei übereinander angeordnete Transistoren realisiert weren, die über eine gemeinsame dotierte Schicht, die als gemeinsame Source-Drain-Schicht wirkt, in Reihe verschaltet sind;

- bei dem durch Strukturieren der dotierten Schichten Stege gebildet werden;
- bei dem mindestens eine Seitenwand der Stege mit einem Gate-Dielektrikum versehen wird;
- bei dem Wortleitungen gebildet werden, die quer zu den Stegen verlaufen und die jeweils im Bereich der Seitenwand an das Gate-Dielektrikum angrenzen, wobei die als Source-Drain wirkenden dotierten Schichten als Bitleitungen wirken.

**15.** Verfahren nach Anspruch 14, bei dem die dotierten Schichten durch Epitaxie aufgebracht werden.

**Claims**

**1.** Memory cell arrangement,

- in which webs are arranged on a main area of a semiconductor substrate and project above the main area of the semiconductor substrate,
- in which the webs each have a stack of doped layers in which mutually adjacent layers are in each case doped by the opposite conductivity type,
- in which three adjacent doped layers in each case form two source/drain regions and a channel region of a transistor,
- in which at least one sidewall of the stacks is provided with a gate dielectric,
- in which word lines run transversely with respect to the webs and in each case adjoin the gate dielectric in the region of the sidewalls of the stacks,
- in which doped layers acting as source/drain region act as bit lines,
- in which enough doped layers are provided in the stack that at least two transistors are realized by the doped layers, which transistors are arranged one above the other and are connected up in series via a common doped layer, which acts as a common source/drain region.

**2.** Memory cell arrangement according to Claim 1, in which enough doped layers are provided in the stack that in each case between 4 and 32 transistors are arranged one above the other in the webs, which transistors are connected up in series in each case via a common doped layer, which acts as a common source/drain region.

**3.** Memory cell arrangement according to Claim 1 or 2, in which a plurality of word lines, which are spaced apart from one another, in each case run transversely with respect to the webs.

**4.** Memory cell arrangement according to one of Claims 1 to 3, in which doped layers acting as channel region in each case have a dopant concentration corresponding to one of two different dopant concentration values in the crossover region with one of the word lines.

**5.** Memory cell arrangement according to Claim 4, in which the two different dopant concentration values differ from one another by a factor of 2 to 10.

**6.** Memory cell arrangement according to Claim 4 or 5,

- in which one of the two different dopant concentration values lies between $0.5 \times 10^{18}$ cm$^{-3}$ and $2 \times 10^{18}$ cm$^{-3}$,

- in which the other of the two different dopant concentration values lies between $0.5 \times 10^{19}$ cm$^{-3}$ and $2 \times 10^{19}$ cm$^{-3}$.

**7.** Memory cell arrangement according to one of Claims 1 to 6, in which the gate dielectric contains a material having charge carrier traps.

**8.** Memory cell arrangement according to one of Claims 1 to 7,

in which the gate dielectric contains a multilayer system.

9. Memory cell arrangement according to one of Claims 1 to 8,
in which the webs each contain two layer stacks separated by an insulation region.

10. Memory call arrangement according to Claim 9,
in which each two layer stacks arranged in adjacent webs are connected up in series via a doped region which is arranged in the semiconductor substrate and adjoins the main area.

11. Memory cell arrangement according to Claim 9 or 10,
in which layer stacks contained in a web are connected up in series by means of a common conductive layer arranged above the layer stacks and the insulation region.

12. Memory cell arrangement according to one of Claims 1 to 11,
in which a decoder for driving the bit lines is provided and has MOS transistors connected between two bit lines in each case.

13. Memory cell arrangement according to Claim 12,
in which the decoder contains series-connected MOS transistors which are arranged one above the other in the webs.

14. Method for fabricating a memory cell arrangement,

- in which doped layers are applied one above the other to a main area of a semiconductor substrate, adjacent doped layers in each case being doped by the opposite conductivity type, three adjacent doped layers in each case forming two source/drain regions and a channel region of a transistor, enough doped layers being provided that at least two transistors are realized by the doped layers, which transistors are arranged one above the other and are connected up in series via a common doped layer, which acts as a common source/drain layer;
- in which webs are formed by structuring the doped layers,
- in which at least one sidewall of the webs is provided with a gate dielectric,
- in which word lines are formed which run transversely with respect to the webs and in each case adjoin the gate dielectric in the region of the sidewall, the doped layers which act as source/drain acting as bit lines.

15. Method according to Claim 14,
in which the doped layers are applied by epitaxy.

## Revendications

1. Dispositif à cellule de mémoire,

- dans lequel il est prévu, sur une surface principale d'un substrat semiconducteur, des nervures qui font saillie de la surface principale du substrat semiconducteur,
- dans lequel les nervures comportent respectivement une pile de couches dopées, dans laquelle des couches voisines l'une de l'autre sont dopées respectivement par un type de conductivité opposé,
- dans lequel respectivement trois couches dopées voisines forment deux zones de source/drain et une zone de canal d'un transistor,
- dans lequel au moins une paroi latérale de la pile est munie d'un diélectrique de grille,
- dans lequel il s'étend transversalement aux nervures des lignes de mots qui sont adjacentes au diélectrique de grille respectivement dans la région des parois latérales de la pile,
- dans lequel des couches dopées agissant comme zone de source/drain servent de lignes de bits,
- dans lequel il est prévu dans la pile tant de couches dopées qu'il est réalisé par les couches dopées au moins deux transistors superposés, qui sont montés en série par une couche dopée commune qui sert de zone commune de source/drain.

2. Dispositif à cellule de mémoire suivant la revendication 1, dans lequel il est prévu dans la pile tant de couches dopées qu'il est superposé dans les nervures respectivement entre 4 et 32 transistors qui sont montés en série par une couche dopée commune qui sert de zone commune de source/drain.

3. Dispositif à cellule de mémoire suivant la revendication 1 ou 2, dans lequel il s'étend transversalement aux nervures respectivement plusieurs lignes de mots qui sont à distance les unes des autres.

4. Dispositif à cellule de mémoire suivant l'une des revendications 1 à 3, dans lequel des couches dopées servant de zone de canal ont respectivement, dans la région de croisement avec l'une des lignes de mot, une concentration en substance de dopage qui correspond à l'une de deux valeurs différentes de concentration de substance de dopage.

5. Dispositif à cellule de mémoire suivant la revendication 4, dans lequel les deux valeurs différentes de concentration de substance de dopage diffèrent l'une de l'autre d'un facteur de 2 à 10.

**6.** Dispositif à cellule de mémoire suivant la revendication 4 ou 5,

- dans lequel l'une des deux valeurs différentes de concentration de substance de dopage est comprise entre $0,5 \times 10^{18}$ cm$^{-3}$ et $2 \times 10^{18}$ cm$^{-3}$,
- dans lequel l'autre des deux valeurs différentes de concentration de substance de base est comprise entre $0,5 \times 10^{19}$ cm$^{-3}$ et $2 \times 10^{19}$ cm$^{-3}$.

**7.** Dispositif à cellule de mémoire suivant l'une des revendications 1 à 6, dans lequel le diélectrique de grille contient un matériau ayant des pièges de porteurs de charge.

**8.** Dispositif à cellule de mémoire suivant l'une des revendications 1 à 7, dans lequel le diélectrique de grille est un système à plusieurs couches.

**9.** Dispositif à cellule de mémoire suivant l'une des revendications 1 à 8, dans lequel les nervures comportent respectivement deux piles de couches séparées par une région d'isolement.

**10.** Dispositif à cellule de mémoire suivant la revendication 9, dans lequel deux piles de couches dans des nervures voisines sont montées en série par une zone de dopage qui est disposée dans le substrat semiconducteur et qui est adjacente à la surface principale.

**11.** Dispositif à cellule de mémoire suivant la revendication 9 ou 10, dans lequel une pile de couches contenue dans une nervure sont montées en série par une couche conductrice commune qui est disposée au dessus de la pile de couches et de la région d'isolement.

**12.** Dispositif à cellule de mémoire suivant l'une des revendications 1 à 11, dans lequel il est prévu un décodeur de commande des lignes de bits, décodeur qui comporte des transistors MOS montés entre respectivement deux lignes de bits.

**13.** Dispositif à cellule de mémoire suivant la revendication 12, dans lequel le décodeur comporte des transistors MOS montés en série, qui sont superposés dans les nervures.

**14.** Procédé de fabrication d'un dispositif à cellule de mémoire,

- dans lequel on dépose, sur une surface principale d'un substrat semiconducteur, de manière superposée des couches dopées, des couches dopées voisines étant dopées respectivement d'un type de conductivité opposé, respectivement trois couches dopées voisines formant deux zones de source-drain et une zone de canal d'un transistor,

- et il est prévu tant de couches dopées qu'il est réalisé par les couches dopées au moins deux transistors superposés qui sont montés en série par une couche dopée commune qui sert de couche commune de source-drain,
- dans lequel on forme des nervures en structurant les couches dopées,
- dans lequel on munit au moins une paroi latérale des nervures d'un diélectrique de grille,
- dans lequel on forme des lignes de mots qui s'étendent transversalement aux nervures et qui sont respectivement adjacentes au diélectrique de grille dans la région de la paroi latérale, les couches dopées agissant comme source-drain servant de lignes de bit.

**15.** Procédé suivant la revendication 14, dans lequel on dépose les couches dopées par épitaxie.

# FIG 1

p+

p

n

195

10

20

40

40

40

60

40

30

70

185

50

175

30

30    90a    30    90a    30    90a    30    90a

# FIG 2

# FIG 3